# EUROPEAN PATENT APPLICATION

(11) **EP 4 626 154 A1**
(43) Date of publication of application: **01.10.2025**
(21) Application number: 25165920.7
(22) Date of filing: 25.03.2025
(51) Int. Cl.: H05K 5/00, H05K 7/20

(54) **ELECTRONIC INPUT/OUTPUT APPARATUS WITH IMPROVED DISSIPATION**

(30) Priority: 28.03.2024 IT 202400007009
(71) Applicant: Dab Pumps S.p.A., 35035 Mestrino (Padova) (IT)
(72) Inventor: BAGNAI, Giacomo, 35035 Mestrino (PD) (IT); ZENI, Marco, 35035 Mestrino (PD) (IT)
(74) Representative: De Filippis, Sara

(57) **Abstract**

The invention relates to an input/output electronic apparatus (100) with improved dissipation for pumps and/or pumping systems comprising an electronic control board (2) having a plurality of components (21) and one or more vias (23), a dissipator (3) configured to dissipate the heat produced by the electronic control board (2), a thermally conductive insulating element (6) interposed between the electronic control board (2) and the dissipator (3), so as to increase the transmission of the heat outgoing from the vias (23) in the direction of the dissipator (3), wherein the components (21) are arranged on the surface of the electronic control board (2) opposite the surface facing the dissipator (3).

## Description

The present invention concerns an electronic input/output apparatus, in particular of a current, with improved dissipation.

### Field of invention

The invention fits into the technical field of electronic devices for pumps and pumping systems, in particular in the technical field of electronic devices for controlling the input and output of a current, such as inverters or similar.

### Prior art

It is known in the sector that pumping systems and in particular pumps require electronic input/output devices such as current inverters or inverters for their correct functioning.

These devices, despite being generally known in any field and sector of electronics, still have some limitations when applied to pumps or pumping systems.

These limitations are due to the need to create such electronic input/output devices according to certain size or positioning constraints of the components. For example, traditional electronic input/output devices are limited by the size and positioning of the electronic control boards that are inside them.

These constraints are also linked to the particular and necessary arrangement that the components of the electronic board must assume to guarantee the suitable functioning of the electronic input/output devices in relation to parameters such as heat dissipation and electromagnetic emission.

Other disadvantages, however, are related to the lack of compactness of the internal components of the electronic input/output devices, which therefore lead to an increase in size and overall dimensions.

Traditional electronic input/output devices also have some disadvantages due to their assembly and installation.

More in detail, it is currently complex and not very repeatable to fix and connect the internal components of these devices such as the electronic board and the dissipator.

In fact, according to the prior art, the electronic board and dissipator, due to their positioning, must be fixed by means of fastening elements positioned manually by a user who assembles the components, making these operations more expensive, less repeatable, and not achievable in an automated manner.

Another limitation is given by the fact that, according to the prior art the dissipators face the surface of the electronic control board in which the components are present, making the assembly and disassembly of the various components even more complex, long, and laborious.

This complexity forces carring out these actions manually in a manner that cannot be automated and is not very repeatable.

This configuration, in which the dissipator is placed close to the components of the electronic control board also makes it more complex to position electronically insulating thermal conductors on the electronic board due to the poor flatness of the face of the electronic board facing the dissipator.

There is therefore a need to create electronic input/output devices such as current inverters or inverters with improved characteristics and performance.

### Purpose of the invention

The aim of the present invention is therefore to provide an electronic input/output device with improved dissipation capable of solving the drawbacks and critical issues mentioned above.

Another purpose of the present invention is to create an electronic input/output apparatus with improved dissipation, which is more efficient, long-lasting and with better heat diffusion than prior art devices.

A further purpose of the present invention is to provide an electronic input/output apparatus with improved dissipation which allows you to increase the efficiency of the dissipator and reduce thermal resistance.

Another purpose of the present invention is to create an electronic input/output apparatus with improved dissipation, which allows the components of the electronic board to be used as a dissipator enhancement.

A further purpose of the present invention is to provide an electronic input/output apparatus with improved dissipation, which is easily connectable and disassembled.

Another purpose of the present invention is to create an electronic input/output apparatus with improved dissipation, which simplifies and optimizes the assembly of the components.

A further purpose of the present invention is to provide an electronic input/output apparatus with improved dissipation which makes the production and assembly process simpler, quicker, cheaper, and more repeatable even automatically.

Another purpose of the present invention is to create an electronic input/output apparatus with improved dissipation, which simplifies the connection and the fixing between the dissipator and the electronic board.

A further object of the present invention is to provide an electronic input/output apparatus with improved dissipation which allows the electronic components of the electronic control board to be arranged in a more compact manner and allows the electromagnetic emissions of these components to be reduced.

Another purpose of the present invention is to create an electronic input/output apparatus with improved dissipation which allows the electronic components of the electronic control board to be arranged on the opposite side of the dissipator, reducing interference.

Another object of the present invention is to create an electronic input/output apparatus with improved dissipation, which allows the electronic components of the electronic board to be arranged in a close position to have a single and narrower dissipation and emission area.

A further aim of the present invention is to provide an electronic input/output apparatus with improved dissipation that is easy and economical to manufacture by virtue of the advantages achieved.

These and other purposes are achieved by an electronic input/output device with improved dissipation according to the attached independent claim.

Further detailed technical features are reported in the attached dependent claims.

It is therefore object of the present invention an input/output electronic apparatus with improved dissipation for pumps and/or pumping systems comprising: an electronic control board having a plurality of components and one or more vias, a dissipator configured to dissipate the heat produced by said electronic control board, a thermally conductive insulating element interposed between said electronic control board and said dissipator to increase the transmission of the heat outgoing from said vias in the direction of said dissipator, wherein said one or more components are arranged on the surface of said electronic control board opposite the surface facing said dissipator.

In a preferred embodiment, the through-hole of said one or more vias is filled with the same material as said electronic control board.

Preferably, the vias are capped.

Still, preferably, the thermally conductive insulating element is a thermally conductive elastic mat or a SilPad.

### Brief description of the figures

The present invention will be now described, for illustrative but not limitative purposes, according to its preferred embodiments, with particular reference to the figures of the enclosed drawings, wherein:
- figure 1 is a sectional view of the internal components of the electronic input/output device with improved dissipation according to the invention;
- figure 2 is a top view of the electronic control board of the electronic input/output device with improved dissipation according to the invention;
- figure 3 shows a detail of the electronic control board in figure 2;
- figure 4 is an exploded view of the electronic input/output device with improved dissipation according to the invention;
- figure 5 is a sectional view of the electronic input/output device with improved dissipation according to the invention;
- figures 6A and 6B are two side views of the outside of the electronic input/output device with improved dissipation according to the invention.

### Detailed description

With reference to the figures mentioned, a preferred embodiment of an electronic input/output device with improved dissipation according to the invention is shown.

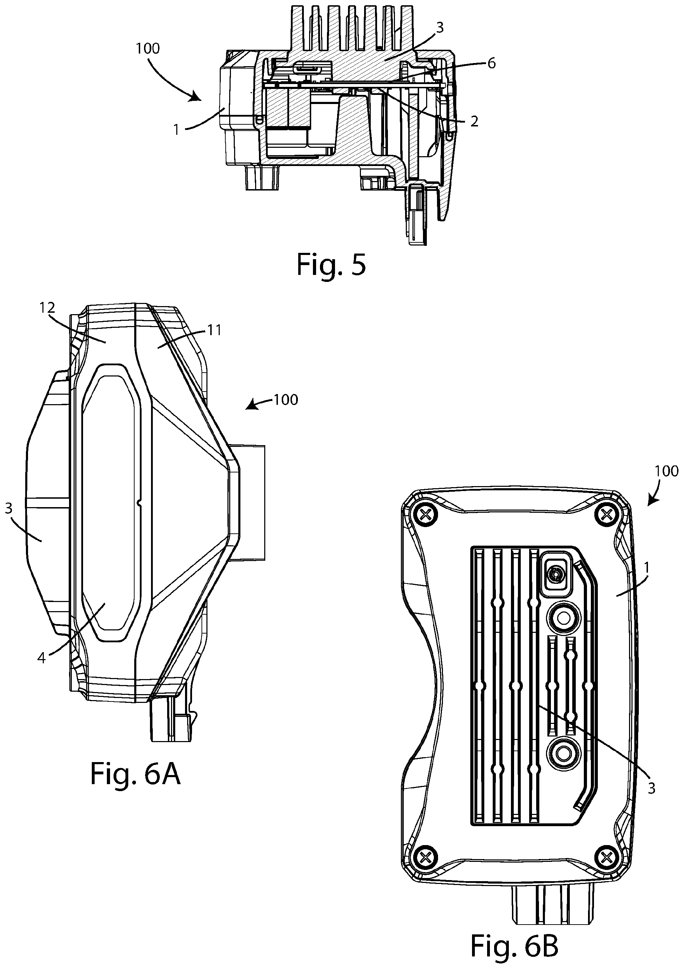

Referring to the figures above, the electronic input/output apparatus with improved dissipation object of the invention is indicated with the numerical reference 100 and, in its first embodiment, according to the present invention, it comprises a casing 1 for housing the various components inside it, an electronic control board 2 and a dissipator 3 (fig. 5).

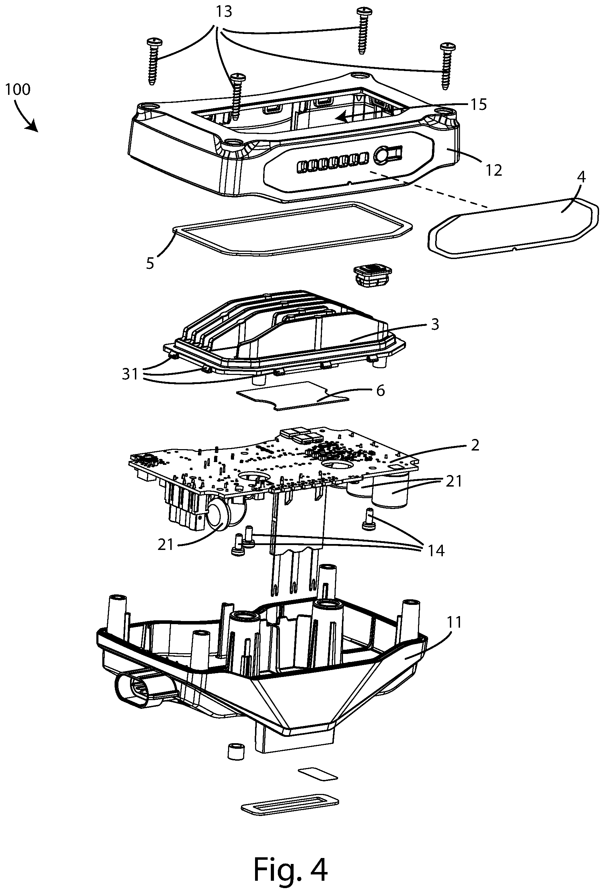

With reference to figure 4, in preferred embodiments, the casing 1 comprises a board holder 11 and a cover 12.

Advantageously, the board holder 11 and the cover 12 are fixed by means of suitable fastening elements 13.

Again advantageously, the cover 12 can have an opening 15 to allow the escape of at least a portion of the dissipator 3.

Again advantageously, the board holder 11 is shaped to have one or more seats, in which the components 21 of the electronic control board 2 are arranged.

These seats allow a more compact housing of the electronic board 2 and an overall reduction in the volumes of the electronic apparatus 100.

In detail, the casing 1 and, in particular, the board holder 11 are shaped so as to be able to house the components present on the board 2 and support the board 2 itself, so that it is as close as possible to the dissipator.

The casing 1 can also have a display 4 for watching parameters, signals and information and for controlling, and managing the electronic input/output device by a user.

In the embodiments visible in figures 4 and 6A, the display 4 is present on the cover 12 of the casing 1.

Advantageously, the display 4 can be positioned in a portion of the casing 1 easily reachable by a user.

Even more advantageously, the display 4 is of the touch-screen type, and has a layout and interface that is highly comprehensible and intuitive to the user.

Again with reference to figure 4, preferably, a gasket 5 is placed between the casing 1 and the dissipator 3.

Other gaskets may be present in other positions depending on needs and requirements.

The dissipator 3 and the electronic control board 2 are fixed to each other by means of further fastening elements 14.

The dissipator 3 can have protruding elements 31 capable of interlock into respective holes present in the casing 1 to improve the fixing between the dissipator 3 and the casing 1.

In the embodiments visible in the figures, the dissipator 3 interlocks onto the cover 12.

To optimize the space, the electronic control board 2 is arranged to have the components 21 facing toward the motor, i.e. towards the opposite side to the dissipator 3.

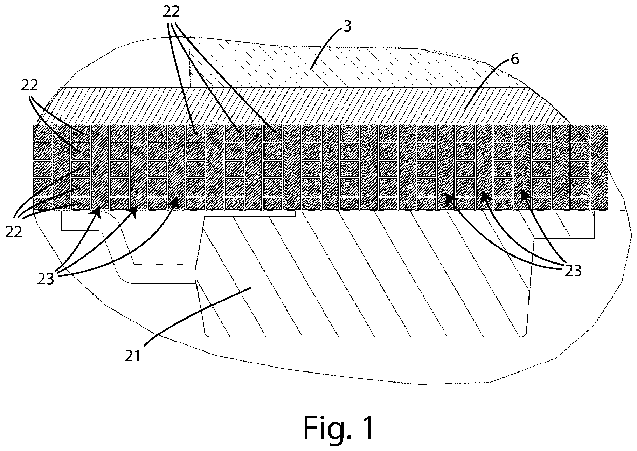

Referring to figure 1, a section of the internal components of the electronic input/output apparatus with improved dissipation 100.

More in detail, it is observable how between the electronic control board 2, having at least one component 21 that emits heat to be dissipated, and the dissipator 3 there is a thermally conductive insulating element 6.

The thermally conductive insulating element 6 is placed in contact with a wall of the electronic board 2, in particular, the wall in which the components 21 are not present, and with the dissipator 3, so as to create thermal contact between the two elements.

In a preferred embodiment of the invention, this thermally conductive insulating element 6 is an elastic thermally conductive mat or a SilPad.

Advantageously, the thermally conductive insulating element 6 is elastic.

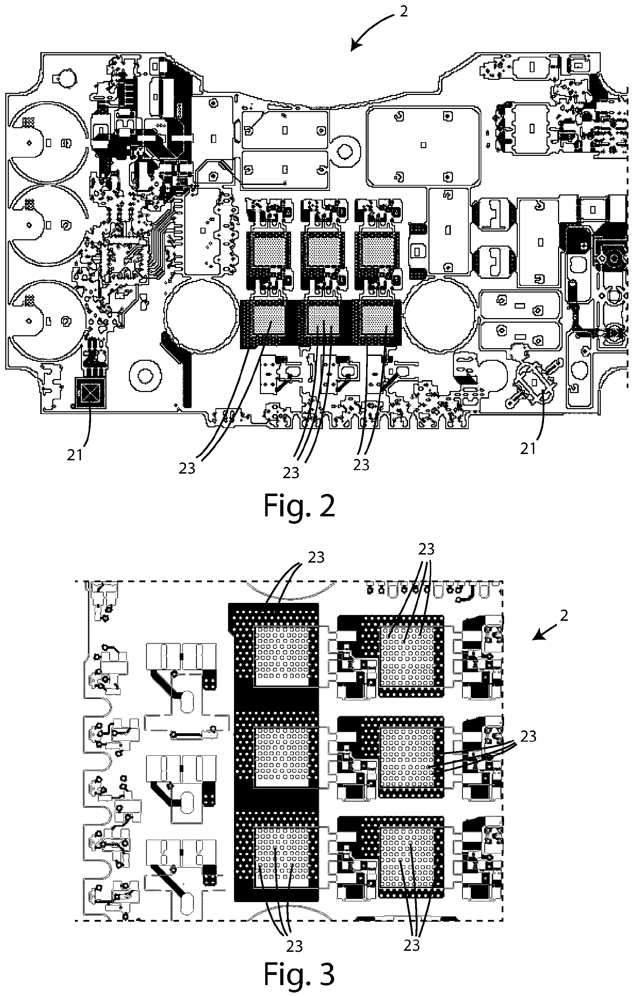

Again, with reference to figure 2, it is visible how the electronic board 2 has a plurality of layers 22.

The electronic control board 2 can in fact be of the single-layer or multi-layer type.

The electronic control board 2 and, in particular, the layers 22 are crossed by one or more vias 23.

In the case of a multilayer electronic board 2, the vias 23 can pass through all the layers of the electronic board or they can also be blind or buried vias 23.

The diversity of the vias 23 depends on the construction and use requirements of the electronic board 2 of the input/output device 100.

In the embodiments observable in the figures, the electronic control board 2 is completely crossed, from one end to the other, by one or more vias 23.

The vias 23 allow the electronic connection of the states 22 of the electronic control board 22, but also allow the heat produced by the components 21 and the other components of the apparatus 100 to pass through the same electronic control board 2.

The vias 23 in fact have a covering of current-conducting metallic material, for example copper, inside which there is a through hole. The metallic covering material allows the electrical connection between two or more overlapping layers of the electronic board 2, while the through hole allows the passage of heat through the electronic board 2.

More in detail, the vias 23 allow the heat to pass through the electronic board 2 towards the dissipator 3.

In preferred embodiments, the vias 23 are capped to increase heat transmission.

Advantageously, through the capping, it is possible to use the electronic board 2 as an enhancement of the dissipator 3.

In further embodiments, the through hole of each way 23 is filled with the same material in which the layers of the electronic control board 2 are made.

This advantageously allows the heat to be dissipated even in a direction transversal to the via 23 itself.

The thermally conductive insulating element 6 further favors the transmission of heat to the dissipator 3 while avoiding electronic conduction.

Advantageously, the thermally conductive insulating element 6 also allows filling the spaces present on the surface of the electronic board 2 facing the dissipator 3, compensating for the non-flatness of this surface of the electronic board 2.

In fact, the electronic board 2, on its surface facing the dissipator 3, may present depressions or protrusions due to the presence of printed circuits, soldering, etc.

Air is generally positioned in these spaces, which reduces the transmission of heat towards the dissipator 3.

The thermally conductive insulating element 6 instead allows these spaces to be filled, eliminating the air, in order to reduce thermal resistance and improve heat conduction.

Again advantageously, the thermally conductive insulating element 6 allows the flatness of the electronic board 2 to be increased, creating a flat conductive surface, in which the dissipator 3 comes into contact more efficiently.

Furthermore, the thermally conductive insulating element 6 and the vias 23 favor the transmission of heat from the components 21, even if they are arranged on the wall of the electronic board 2 opposite to that in which the dissipator 3 is located.

This aspect allows the electronic board to be positioned so that its components 21 are positioned on the opposite side with respect to the dissipator 3, but at the same time ensuring optimal heat dissipation by the electronic input/output device 100.

In fact, the heat produced by the components 21 passes through the vias 23 toward the dissipator 3.

Advantageously, in this way, it is also possible to position the dissipator 3, so that a portion of it protrudes from the casing 1 (figures 5 and 6A) and is in contact with the air.

In fact, due to the vias 23 and the thermally conductive insulating element 6, the heat produced by the components 21 can pass through the electronic board 2 and reach the dissipator 3 located towards the outside of the casing 1.

In the absence of these aspects, as happens in traditional electronic input/output devices, the dissipator 3 should necessarily be placed on the side of the electronic board 2 where the components 21 are present because otherwise, it would not be able to effectively dissipate the produced heat.

This positioning would increase the dimensions and overall sizes of known electronic input/output devices, increase the complexity of assembling the components, and reduce their overall performance.

Furthermore, electronic input/output devices without the vias 23 and the thermally conductive insulating element 6 would be forced to position the dissipator near the motor, which also produces heat, reducing the performance of the dissipator and the pump itself.

On the contrary, the electronic input/output apparatus 100 according to the invention allows the dissipator to be positioned in contact with the air and on the opposite side with respect to the motor and the components 21 of the electronic board 2, facilitating its assembly and reducing its dimensions.

In fact, the electronic input/output apparatus 100 with improved dissipation allows creating a more streamlined and efficient layout of the components, which improves the efficiency and performance of the apparatus 100 and reduces its dimensions.

Advantageously, the arrangement of the components of the electronic input/output apparatus 100 according to the invention allows simpler and more automatable assemblies.

These layout advantages also allow the display to be positioned in positions that are more easily accessible to users.

Still advantageously, according to the invention, it is possible to achieve a better thermal separation from the motor, to further improve the diffusion of the dissipator 3 and the performance of the electronic input/output device 100.

Still advantageously, it is possible to create an electronic input/output apparatus 100 with simple and not bulky shapes.

Advantageously, the electronic input/output apparatus 100 allows obtaining a more compact arrangement of the components 21 which corresponds to a lower emission of electromagnetic waves.

This lower emission of electromagnetic waves allows the achievement of numerous EMC certifications.

From the description given, the characteristics of the electronic input/output apparatus with improved dissipation, object of the invention, just as the advantages are clear.

It is clear, finally, that numerous other variations can be made to the apparatus at issue, without departing from the principles of novelty inherent in the inventive idea, just as it is clear that, in the practical implementation of the invention, the materials, the shapes and the dimensions of the illustrated details may be any according to needs and they may be replaced with other equivalent ones.

Where the features and techniques mentioned in any claims are followed by reference marks, such reference marks have been included for the sole purpose of increasing the intelligibility of the claims and, accordingly, such reference marks have no limiting effect on the interpretation of each element identified by way of example by these reference signs.

## Claims

1. An input/output electronic apparatus (100) with improved dissipation for pumps and/or pumping systems comprising:
- an electronic control board (2) having a plurality of components (21) and one or more vias (23),
- a dissipator (3) configured to dissipate the heat produced by said electronic control board (2);
- a thermally conductive insulating element (6) interposed between said electronic control board (2) and said dissipator (3), so as to increase the transmission of the heat outgoing from said vias (23) in the direction of said dissipator (3),
**characterised in that** said one or more components (21) are arranged on the surface of said electronic control board (2) opposite the surface facing said dissipator (3).

2. Input/output electronic apparatus (100) according to claim 1 **characterised in that** the through-hole of said one or more vias (23) is filled with the same material as said electronic control board (2).

3. Input/output electronic apparatus (100) according to claim 1 **characterised in that** said one or more vias (23) are capped.

4. Input/output electronic apparatus (100) according to claim 1 **characterised in that** said thermally conductive insulating element (6) is a thermally conductive elastic mat or a SilPad.
